Europäisches Patentamt

European Patent Office

Office européen des brevets

(11) Veröffentlichungsnummer: **0 310 836**

**A2**

## (12) EUROPÄISCHE PATENTANMELDUNG

(21) Anmeldenummer: **88115138.5**

(22) Anmeldetag: **15.09.88**

(51) Int. Cl.4: **H01L 29/06**

(30) Priorität: **08.10.87 DE 3734087**

(43) Veröffentlichungstag der Anmeldung:
**12.04.89 Patentblatt 89/15**

(84) Benannte Vertragsstaaten:
**CH DE FR GB LI SE**

(71) Anmelder: **Siemens Aktiengesellschaft Berlin
und München**
**Wittelsbacherplatz 2**
**D-8000 München 2(DE)**

(72) Erfinder: **Stengl, Reinhard**
**Bergstrasse 3**
**D-8901 Stadtbergen(DE)**
Erfinder: **Gösele, Ulrich, Dr. habil.**
**3008 Eubanks Road**
**Durham North Carlolina N.C. 277 07(US)**

(54) **Halbleiterbauelement mit einem planaren pn-Übergang.**

(57) Ein in einen Halbleiterkörper (1) eingefügtes Halbleitergebiet (2a, 2b), das durch einen planaren pn-Übergang (3a, 3b) von diesem getrennt ist, weist ein erstes, stärker dotiertes Teilgebiet (2a) und ein zweites, schwächer dotiertes Teilgebiet (2b) auf, das durch einen sich einer Grenzfläche (1a) des Halbleiterkörpers allmählich annähernden Teil (3b) des pn-Übergangs begrenzt wird. Eine das Halbleitergebiet (2a, 2b) kontaktierende Elektrode (6) überdeckt einen Teil des zweiten Teilgebiets (2b) und ist der lateralen Begrenzung (4) des Halbleitergebiets (2a, 2b) soweit angenähert, daß beim Anlegen einer den pn-Übergang (3a, 3b) sperrenden Spannung die sich an diesem ausbildende Raumladungszone mit ihrem in der Grenzfläche (1a) liegenden Rand (11) den Elektrodenrand (13) bei einer reduzierten Durchbruchspannung gerade erreicht.

FIG 1

## Halbleiterbauelement mit einem planaren pn-Übergang

Die Erfindung bezieht sich auf ein Halbleiterbauelement nach dem Oberbegriff des Patentanspruchs 1.

Ein derartiges Bauelement ist z.B. der EP-A-0 176 778 entnehmbar. Wenn hier eine den pn-Übergang sperrende, über Elektroden zugeführte Spannung auf den Wert einer sog. Durchbruchspannung erhöht wird, erfolgt ein lokaler Durchbruch des pn-Übergangs, bei dem sehr häufig eine thermische Überlastung und damit Zerstörung des Halbleiterbauelements eintritt. Der lokale Durchbruch erfolgt bei diesem bekannten Bauelement etwa dort, wo der parallel zur Grenzfläche des Halbleiterkörpers verlaufende Teil des pn-Übergangs in den sich allmählich der Grenzfläche annähernden Teil desselben übergeht.

Andererseits ist der lokale Durchbruch eines pn-Übergangs auch bei Leistungsthyristoren von großer Bedeutung. Diese bestehen aus einem Halbleiterkörper mit vier aneinander grenzenden Halbleiterschichten abwechselnder Leitungstypen, nämlich einem n-Emitter, einer p-Basis, einer n-Basis und einem p-Emitter. Erhöht man eine den Thyristor blockierende, zwischen seinem kathodenseitigen und anodenseitigen Anschluß angelegte Spannung auf den Wert der Durchbruchspannung, so erfolgt ein lokaler Durchbruch des pn-Übergangs, der die p-Basis von der n-Basis trennt und etwa parallel zu einer Grenzfläche des Halbleiterkörpers verläuft. Im allgemeinen tritt der Durchbruch an dem in der Seitenfläche des Thyristors liegenden Rand dieses pn-Übergangs auf. Zur Vermeidung eines solchen unkontrollierbaren und sehr oft zur Zerstörung des Thyristors führenden lokalen Durchbruchs ist es aus der EP-A-0 088 967 bekannt, den pn-Übergang zwischen der p-Basis und der n-Basis durch Bestrahlung mit einem Laserstrahl unterhalb der zentralen Zündelektrode des Thyristors mit einer die Dicke der n-Basisschicht ver ringernden Ausbuchtung zu versehen und damit bereits bei einer reduzierten Durchbruchspannung einen kontrollierbaren Durchbruch herbeizuführen, der im Bereich der Ausbuchtung auftritt. Dieser kontrollierbare Durchbruch führt zu einer Überkopfzündung des Thyristors, bei der eine thermische Zerstörung wegen der reduzierten Durchbruchspannung nicht eintritt. Nachteilig ist jedoch, daß die reduzierte Durchbruchspannung hierbei nicht mit der gewünschten Genauigkeit und Reproduzierbarkeit auf einen bestimmten Spannungswert eingestellt werden kann.

Der Erfindung liegt die Aufgabe zugrunde, ein Halbleiterbauelement der eingangs genannten Art anzugeben, bei dem der pn- Übergang beim Erreichen einer in einfacher Weise einstellbaren, reduzierten Durchbruchspannung in definierter Weise durchbricht, ohne daß hierdurch eine thermische Zerstörung des Bauelements eintritt. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß eine reduzierte Durchbruchspannung, bei der der pn-Übergang des Halbleiterbauelements durchbricht, ohne daß das letztere hierdurch Schaden erleidet, mit hinreichender Genauigkeit und Reproduzierbarkeit eingestellt werden kann.

Die Ansprüche 2 bis 6 sind auf bevorzugte Ausgestaltungen und Weiterbildungen der Erfindung gerichtet.

Die Erfindung wird nachfolgend anhand der in der Zeichnung dargestellten, bevorzugten Ausführungsbeispiele näher erläutert. Dabei zeigt:

Fig. 1 eine nach der Erfindung ausgebildete Leistungsdiode,

Fig. 2 einen erfindungsgemäßen Leistungsthyristor und

Fig. 3 eine Modifikation des Thyristors nach Fig. 2.

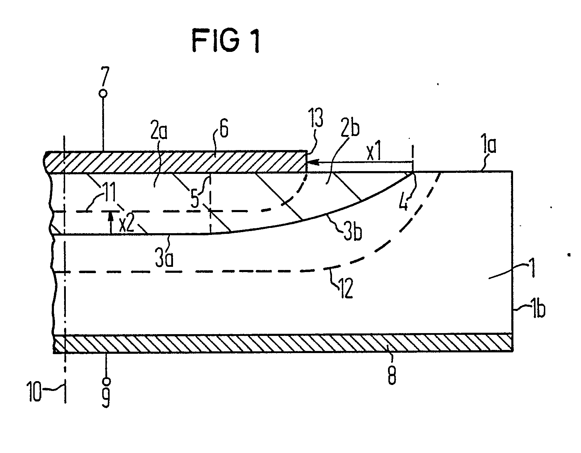

In Fig. 1 ist der Querschnitt eines Halbleiterkörpers 1, z.B. aus n-dotiertem Silizium mit einer Dotierungskonzentration von $10^{14}\,cm^{-3}$, dargestellt, in den ein p-leitendes Halbleitergebiet 2a, 2b eingefügt ist. Letzteres ist durch einen planaren pn-Übergang 3a, 3b von dem übrigen Teil des Halbleiterkörpers 1 getrennt. Ein erstes Teilgebiet 2a des genannten Halbleitergebiets wird durch ein zentrales, etwa parallel zur Grenzfläche 1a des Halbleiterkörpers verlaufendes Teil 3a des pn-Übergangs begrenzt. Ein zweites Teilgebiet 2b wird durch ein weiteres Teil 3b des pn-Übergangs begrenzt. Dabei schließt sich das Teil 3b des pn-Übergangs an das Teil 3a an und nähert sich in seinem weiteren Verlauf allmählich der Grenzfläche 1a, die es in einer Linie 4 erreicht, welche die laterale Begrenzung des Halbleitergebiets 2a, 2b in der Grenzfläche 1a darstellt. Als Dotierstoff für das Halbleitergebiet 2a, 2b kommt Bor in Frage, wobei die Dotierungskonzentration im Teilgebiet 2a, z.B. $10^{18}\,cm^{-3}$ beträgt, während die Dotierungskonzentration im Teilgebiet 2b ausgehend von einem Wert von etwa $10^{18}\,cm^{-3}$, der an der mit 5 bezeichneten Grenze zum Teilgebiet 2a vorhanden ist, sich in Richtung auf die laterale Begrenzung 4 ständig verringert und an der Begrenzung 4 dann schließlich einen Wert von etwa $10^{14}\,cm^{-3}$ bis $10^{12}\,cm^{-3}$ und kleiner erreicht. Das Halbleitergebiet 2a, 2b wird von einer Elektrode 6 kontaktiert, die mit einem Anschluß 7 versehen ist. Der Halbleiterkörper ist andererseits mit einer Elektrode 8 versehen, die einen Anschluß 9 aufweist. Wenn die Teile 1, 2a, 2b, 6 und 8 rotationssymmetrisch ausgebildet sind, ist die strichpunktierte Linie 10 als Symmetrieachse anzusehen. In diesem Fall sind die laterale Begrenzung 4 des Halbleitergebiets 2a, 2b und die Randfläche des Halbleiterkörpers 1 kreisförmig bzw. als Zylindermantelfläche ausgebildet. Die Herstellung eines solchen Halbleiterbauelements ist in der EP-A-0 176 778 ausführlich beschrieben.

Werden die Anschlüsse 7 und 9 mit einer Spannung beschaltet, die den Halbleiterkörper 1 auf ein positiveres Potential legt, als den Halbleiterbereich 2a, 2b, so wird der pn-Übergang 3a, 3b in Sperrichtung vorgespannt. Dabei bildet sich an diesem eine Raumladungszone aus, deren Grenzen mit 11 und 12 bezeichnet sind. Durch die geringe Dotierungskonzentration des Teil gebiets 2b im Vergleich zum Teilgebiet 2a dringt die Grenze 11 der Raumladungszone in der Grenzfläche 1a bei einer Erhöhung der sperrenden Vorspannung des pn-Übergangs 3a, 3b auf einen Wert Ux um eine Strecke x1 in den Teilbereich 2b vor, während die Grenze 11 oberhalb des zentralen Teils 3a des pn-Übergangs lediglich um einen Betrag x2 vordringt, der etwa einem Drittel von x1 entspricht. Bemißt man nun die Elektrode 6 in ihrer lateralen Ausdehnung so, daß ihr Rand 13 einerseits den Teilbereich 2b kontaktiert und andererseits der lateralen Begrenzung 4 so weit angenähert ist, daß er beim Erreichen einer Sperrspannung Ux von der Grenze 11 gerade erreicht wird, so tritt beim Anlegen von Ux ein kontrollierter Durchbruch des pn-Übergangs 3a, 3b ein. Damit ist Ux als eine reduzierte Durchbruchspannung eindeutig festgelegt. Der beim Vordringen der Grenze 11 der Raumladungszone bis an den Rand 13 der Elektrode 6 auftretende kontroll ierte Durchbruch von 3a, 3b tritt bei einer so weit reduzierten Durchbruchspannung Ux ein, daß das Halbleiterbauelement durch den hierbei fließenden Durchbruchstrom nicht thermisch überlastet bzw. zerstört wird. Ohne die erwähnte Bemessung der Elektrode 6 in lateraler Richtung, also z.B. bei einer das Teilgebiet 2a lateral nicht überragenden Ausdehnung der Elektrode 6, würde der Durchbruch des pn-Übergangs 3a, 3b bei einer höheren Durchbruchspannung Uy erfolgen, was zu einem unkontrollierbaren lokalen Durchbruch des Teils 3b des pn-Übergangs an der lateralen Begrenzung 4 des Teilbereichs 2b oder im Grenzbereich der Teile 3a und 3b führen würde. Ein solcher unkontrollierbarer Durchbruch würde aber in aller Regel zur Zerstörung des Bauelements führen.

Ein erfindungsgemäß herbeigeführter, kontrollierter Durchbruch eines planaren, also in der Grenzfläche 1a lateral begrenzten pn-Übergangs wird auch dann erreicht, wenn die Eindringtiefe des Teilgebiets 2b nicht, wie in Figur 1 dargestellt, in Richtung auf die Begrenzung 4 ganz allmählich abnimmt, sondern auch dann, wenn sie im wesentlichen konstant ist, wobei sich der pn-Übergang im unmittelbaren Bereich der lateralen Begrenzung 4 dieser in einem steilen Anstieg bzw. in vertikaler Richtung annähert. Voraussetzung ist allerdings, daß die Dotierungskonzen tration des Teilgebiets 2b kleiner ist als die Dotierungskonzentration des Teilgebiets 2a, wobei auch ein in lateraler Richtung homogener Dotierungsverlauf im Teilgebiet 2b zulässig ist.

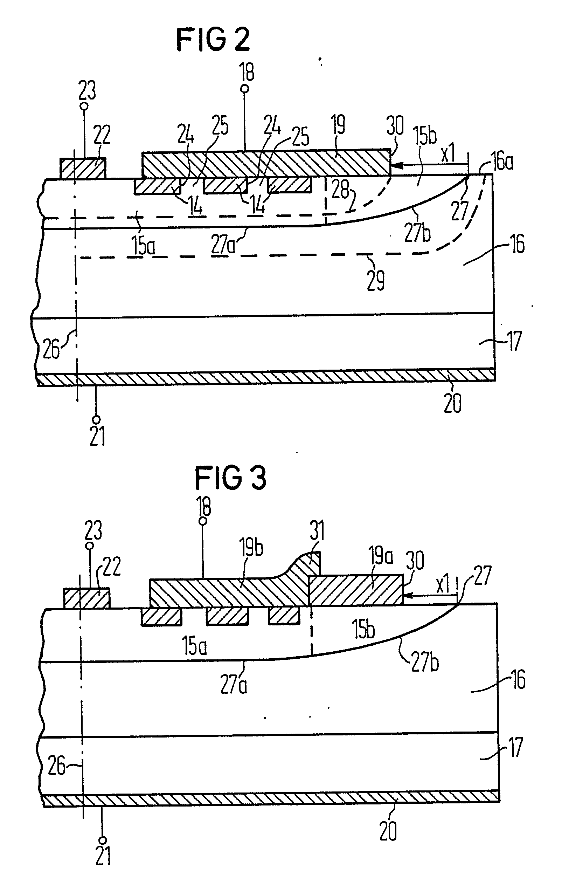

Figur 2 zeigt einen nach der Erfindung ausgebildeten Leistungsthyristor. Er erhält einen n-Emitter 14, eine p-Basis 15a, 15b, eine n-Basis 16 und einen p-Emitter 17. Der n-Emitter 14 wird von einer kathodenseitigen, mit einem Anschluß 18 versehenen Elektrode 19 kontaktiert, der p-Emitter 17 von einer anodenseitigen Elektrode 20, die mit einem Anschluß 21 versehen ist. Eine die p-Basis kontaktierende Zündelektrode 22 ist mit einem Anschluß 23 versehen, der ein positiver Spannungsimpuls zugeführt wird, um den Thyristor zu zünden. Mit 24 sind Ausnehmungen des n-Emitters 14 bezeichnet, die von entsprechenden Ansätzen 25 der p-Basis ausgefüllt werden. Letztere werden von der kathodenseitigen Elektrode 19 in der Grenzfläche 16a kontaktiert. Die Strukturteile 24 und 25 bilden Emitter-Basis-Kurzschlüsse, die eine unerwünschte Zündung des Thyristors beim Anlegen von Blockierspannungen, die den Anschluß 21 auf ein positiveres Potential legen als den Anschluß 18, verhindern. Bei rotationssymmetrischem Aufbau des Thyristors ist die strichpunktierte Linie 26 als Symmetrieachse anzusehen. Zwischen der p-Basis 15a, 15b und der n-Basis 16 befindet sich ein pn-Übergang 27a, 27b, der beim Anlegen einer Blockierspannung an die Anschlüsse 18 und 21 in Sperrichtung vorgespannt wird. Erhöht man die an 27a, 27b liegende Sperrspannung auf den Wert der Durchbruchspannung Uy, so führt der dann entstehende lokale Durchbruch des pn-Übergangs 27a, 27b zu einer unkontrollierbaren Zündung des Thyristors, die diesen thermisch zerstören kann.

Um diese Gefahr zu beseitigen, werden die Teile 15a und 15b, 27a und 27b, 16 und 19 entsprechend den Teilen 2a und 2b, 3a und 3b, 1 und 6 von Figur 1 ausgebildet. 15a ist hierbei ein erster Teilbereich der p-Basis, der stärker dotiert ist als der zweite Teilbereich 15b derselben. Der zweite Teilbereich 15b wird durch eine Begrenzung 27 in der Grenzfläche des Thyristors lateral begrenzt. Die kathodenseitige Elektrode 19 ist soweit in Richtung auf die laterale Begrenzung 27 verlängert, daß sie den Teilbereich 15b kontaktiert und daß die Grenze 28 der sich am gesperrten pn-Übergang 27a, 27b aufbauenden Raumladungszone, deren untere Grenze mit 29 bezeichnet ist, beim Erreichen einer reduzierten Durchbruchspannung Ux gerade um die Strecke x1 in das Teilgebiet 15b hineinerstreckt, so daß die Grenze 28 gerade den Rand 30 der Elektrode 19 erreicht. Damit tritt am pn-Übergang 27a, 27b ein kontrollierter Durchbruch ein, der zwar eine ungewollte Zündung (Überkopfzündung) des Thyristors darstellt, aber wegen der reduzierten Durchbruchspannung Ux nicht zur Zerstörung führt. Ohne die beschriebene planare Ausbildung des pn-Übergangs 27a, 27b, ohne die erwähnte Bemessung der Elektrode 19 und ohne die gegenüber dem Teilgebiet 15a relativ niedrige Dotierung des Teilgebiets 15b würde bei einer Durchbruchspannung Uy, die größer ist als Ux, ein unkontrollierbarer Durchbruch des pn-Übergangs 27a, 27b erfolgen, der den Thyristor zerstören könnte.

Fig. 3 zeigt eine andere Ausgestaltung des Thyristors nach Fig. 2. Hier setzt sich die kathodenseitige Elektrode, die in ihrer lateralen Ausdehnung vollständig der Elektrode 19 von Fig. 2 entspricht, aus einem ersten Teil 19a und einem zweiten Teil 19b zusammen. Dabei besteht 19a aus einer Schicht aus polykristallinem Silizium. Der äußere Rand des Teils 19a ist entsprechend Fig. 2 mit 30 bezeichnet. Der zweite Teil 19b besteht aus einer leitenden Belegung, z.B. aus Al, die nach dem Aufbringen des Teils 19a aufgebracht wird und dieses bei 31 geringfügig überlappt. Mit dieser Ausführungsform wird erreicht, daß der zum kontrollierten Durchbruch des pn-Übergangs 27a, 27b führende Strom, der über die Teile 21, 20, 17, 16 und 15b in das Teil 19a und von diesem in die Teile 19b und 18 fließt, durch den Widerstand des polykristallinen Siliziums begrenzt wird, und somit auch bei einer relativ langsam erfolgenden Zündung des Thyristors keine zu große thermische Belastung darstellt.

Anstelle der oben erwähnten rotationssymmetrischen Ausbildung der in der Zeichnung dargestellten Halbleiterbauelemente können der Halbleiterkörper 1 und der Halbleiterbereich 2a, 2b oder die Teile 14, 15a, 15b, 16 und 17 auch davon abweichende, z.B. rechteckige laterale Begrenzungen aufweisen. Das gleiche gilt für die Elektroden 6, 8, 19, 19a und 19b.

Im Rahmen der Erfindung kann sich auch die Elektrode 6 des Bauelements nach Fig. 1 entsprechend der Elektrode 19a, 19b in Fig. 3 aus einem ersten und einem zweiten Teil zusammensetzen, wobei das erste Teil aus polykristallinem Silizium besteht und das zweite Teil durch eine leitende Belegung, z.B. aus Al, gebildet ist.

Ansprüche

1. Halbleiterbauelement mit einem planaren pn-Übergang (3a, 3b), bei dem an einer Grenzfläche (1a) eines dotierten Halbleiterkörpers (1) eines ersten Leitungstyps ein Halbleitergebiet (2a, 2b) eines zweiten Leitungstyps vorgesehen ist, wobei ein erstes Teilgebiet (2a) desselben durch einen etwa parallel zur Grenzfläche verlaufenden Teil (3a) des pn-Übergangs begrenzt wird und ein zweites Teilgebiet (2b) durch einen sich der Grenzfläche (1a) annähernden und das Halbleitergebiet in der Grenzfläche lateral begrenzenden Teil (3b) des pn-Übergangs vom übrigen Teil des Halbleiterkörpers getrennt ist, bei dem die Dotierungskonzentration des zweiten Teilgebiets (2b) kleiner bemessen ist als die des ersten Teilgebiets (2a) und bei dem das Halbleitergebiet (2a,2b) und der Halbleiterkörper (1) jeweils von einer ersten und zweiten Elektrode (6, 8) kontaktiert werden, **dadurch gekennzeichnet,** daß der Rand (13) der ersten Elektrode (6) das zweite Teilgebiet (2b) kontaktiert und daß dieser Rand (13) der in der Grenzfläche (1a) liegenden lateralen Begrenzung (4) des Halbleitergebiets (2a, 2b) soweit angenähert ist, daß beim Anlegen einer den pn-Übergang (3a, 3b) sperrenden Spannung die sich am pn-Übergang ausbildende Raumladungszone (11, 12) mit ihrem in der Grenzfläche (1a) liegenden Rand (11) den Rand (13) der ersten Elektrode (16) bei einer reduzierten Durchbruchsspannung gerade erreicht.

2. Halbleiterbauelement nach Anspruch 1, **dadurch gekennzeichnet,** daß die Dotierungskonzentration des zweiten Teilgebiets (2b) ausgehend von einem an der Grenze zum ersten Teilgebiet (2a) vorhandenen Wert in Richtung auf die laterale Begrenzung (4) des Halbleitergebiets (2a, 2b) abnimmt.

3. Halbleiterbauelement nach Anspruch 1 oder 2, **dadurch gekennzeichnet,** daß das Halbleitergebiet aus einer ersten Basisschicht (15a, 15b) eines Thyristors besteht, daß der Halbleiterkörper aus einer zweiten Basisschicht (16) und einen an diese angrenzenden zweiten Emitter (17) des Thyristors gebildet ist, daß ein erster Emitter (14) mit einem zum zweiten Emitter (17) entgegengesetzten Leitungstyp in die erste Basisschicht (15a, 15b) eingefügt ist, daß die erste Elektrode aus einer den ersten Emitter (14) und die erste Basisschicht (15a, 15b) kontaktierenden Elektrode (19) besteht, und daß die zweite Elektrode (20) den zweiten Emitter (17) des Thyristors kontaktiert.

4. Halbleiterbauelement nach Anspruch 3, **dadurch gekennzeichnet,** daß die den ersten Emitter (14) und die erste Basisschicht (15a, 15b) kontakierende Elektrode (19a, 19b) aus zwei Teilen besteht, von denen das erste Teil (19a) aus polykristallinem Silizium besteht und das zweite Teilgebiet (15b) der ersten Basisschicht kontaktiert und das zweite Teil (19b) als eine leitende Belegung ausgebildet ist, die das erste Teil (19a) randseitig überlappt.

5. Halbleiterbauelement nach Anspruch 1 oder 2, **gekennzeichnet durch** einen rotationssymmetrischen Aufbau, wobei die erste Elektrode (6) eine kreisförmige laterale Begrenzung (4) aufweist.

6. Halbleiterbauelement nach Anspruch 3 oder 4, **gekennzeichnet durch** einen rotationssymmetrischen Aufbau, wobei die den ersten Emitter (14) und die erste Basisschicht (15a, 15b) kontaktierende Elektrode (19) eine kreisringförmige laterale Begrenzung aufweist und daß in einer zentralen Ausnehmung dieser Elektrode eine die erste Basisschicht (15a, 15b) kontaktierende Zündelektrode (22) angeordnet ist.

## FIG 1

## FIG 2

## FIG 3